# EUROPEAN PATENT APPLICATION

(11) **EP 1 555 754 A1**
(43) Date of publication of application: **20.07.2005**
(21) Application number: 05075018.1
(22) Date of filing: 06.01.2005
(51) Int. Cl.: H03J 1/00, H04H 9/00, G11B 27/00, H03G 3/20, H03G 5/16, H04B 1/20

(54) **Audio system parameter setting based upon operator usage patterns**

(30) Priority: 16.01.2004 US 759322
(71) Applicant: Delphi Technologies, Inc., Troy, MI 48007 (US)
(72) Inventor: Olney, Ross D., Agoura Hills, CA 91301 (US); Hinsberger, James J., Kokomo, IN 46901 (CA)
(74) Representative: Denton, Michael John

(57) **Abstract**

A technique for setting parameters of an audio system (100) initially monitors audio related operator usage patterns (206, 306, 410). The technique then controls an audio source (124, 130) of the audio system (100) based upon the operator usage patterns (210, 310, 412).

## Description

### Technical Field

The present invention is generally directed to an audio system and, more specifically, to setting parameters of an audio system based upon operator usage patterns.

### Background of the Invention

Typically, drivers or operators of automotive audio systems exhibit definite patterns in the usage of the audio systems, for example, as a function of the day of the week and time of the day. In a typical case, a driver may listen to news and traffic reports on a particular radio station that provides news and traffic reports on their morning drive into work, Monday through Friday. That same driver may prefer to listen to music provided by a radio station on the drive home, Monday through Friday, and may prefer to listen to music provided by a compact disc (CD) player in the late evenings and on the weekends. It should be appreciated that changing the audio source in the above case requires the driver to perform various adjustments on the audio system during operation of the vehicle. Further, when another operator utilizes the vehicle, that operator may also desire to modify various operating parameters of the audio system.

Additionally, vehicle drivers may also exhibit usage patterns as a function of a music type or genre. As an example, a driver may prefer a particular tone setting when listening to a radio station, e.g., the driver may boost the bass to its maximum limit when listening to rock stations. Along this line, audio system manufacturers have incorporated certain tone settings, such as rock, country, talk, etc., for automatically setting the tones of the audio system.

In a typical situation, a vehicle occupant must adjust a tone and/or equalization settings of the audio system, depending upon what they are listening to at a particular point in time. For example, when a vehicle occupant switches from an FM country radio station to an AM sports radio station, the driver will typically change the tone settings such that the midrange is boosted for the sports radio station and the treble and bass are boosted for the country radio station. It should be appreciated that while the driver is listening to a particular station, the station may go from providing different genres, such as changing from comedy to talk to playing music, all in a matter of seconds. If the tone settings are set for talk when the radio program changes to music, the tone of the audio provided will generally not be appropriate. Further, audio systems that set a specific tone/equalization based upon the genre of the music do not necessarily provide an optimal tone/equalization for a specific operator.

Another example of operator usage patterns that are typically detectable are that of the volume setting of the audio system when a motor vehicle is, for example, at a highway speed versus idling. A number of car manufacturers have implemented audio systems that provide speed compensated volume (SCV) adjustments. In these types of systems, the volume of the audio system is increased or decreased based upon the car speed. In such systems, it is typical for the audio systems to provide a plurality of settings, which can be manually set by a driver of the vehicle. In this manner, the audio systems have allowed an individual to adjust the SCV feature based upon their own preferences.

What is needed is a technique for setting parameters of an audio system based upon operator usage patterns, without requiring manual input from a motor vehicle operator.

### Summary of the Invention

The present invention is generally directed to a technique for setting parameters of an audio system based upon operator usage patterns. Initially, audio related operator usage patterns are monitored. Next, an audio source is controlled based upon the operator usage patterns.

According to another embodiment of the present invention, an audio source is selected based upon operator listening preferences for a day of the week and a time of the day as determined from the operator usage patterns. According to yet another embodiment of the present invention, the audio source is an AM/FM tuner and the step of controlling the audio source based upon the operator usage patterns includes tuning the AM/FM tuner to an appropriate radio station based upon the operator usage patterns.

According to still another embodiment of the present invention, the audio source is selected at power-up. In the various embodiments of the present invention, the audio source may include an AM/FM tuner, a compact disc (CD) player, a satellite digital audio receiver, a digital versatile disc (DVD) player, a cassette tape player and an MP3 file player, among other such audio sources. According to another embodiment of the present invention, an antenna associated with an AM/FM tuner may be tuned based upon at least one of the operator usage patterns and a motor vehicle location, when radio signal strength is correlated with at least one of the operator usage patterns and the motor vehicle location. It should be appreciated that the motor vehicle location may be provided by, for example, a global positioning system (GPS) receiver.

In another embodiment, a genre associated with the audio provided by the audio source is determined and a tone setting of the audio is adjusted based upon the genre associated with the audio and operator usage patterns. In this embodiment, the operator usage patterns include an operator tone preference for the genre. In still another embodiment, equalization settings of the audio source are adjusted based upon the genre associated with the audio and the operator usage patterns, which include an operator equalization preference for the genre.

In yet another embodiment, a speed of a motor vehicle is determined and a volume of the audio produced by the audio source is adjusted based upon the speed of the motor vehicle and the operator usage patterns, which include an operator volume preference for the speed. In another embodiment, a position of a window of a motor vehicle is determined and a volume of the audio produced by the audio source is adjusted based upon the position of the window of the motor vehicle and operator usage patterns, which include an operator volume preference for the window position.

In still another embodiment of the present invention, a location of a motor vehicle is determined and a volume of the audio produced by the audio source is adjusted based upon a location of the motor vehicle and operator usage patterns, which include an operator volume preference for the location. In this situation, it should be appreciated that a location of a motor vehicle may provide an indication of road noise caused by a current road surface. Thus, according to the present invention, a number of audio related operator parameters may be adjusted based upon a preference of a driver. For example, the audio related operator parameters may include a preferred audio source based on the time of the day and the day of the week, a first preferred volume for an audio source based on the speed of a motor vehicle, a second preferred volume for the audio based on the location of the motor vehicle, a third preferred volume for the audio based on the genre of the audio, a fourth preferred volume for the audio based on the position of a window of the motor vehicle, a preferred tone for the audio based on the genre of the audio and a preferred equalization for the audio based on the genre of the audio.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
Fig. 1 is an exemplary electrical block diagram of an audio system incorporated within a motor vehicle;
Fig. 2 is a flow chart of an exemplary routine for monitoring audio related operator usage patterns;
Fig. 3 is a flow chart of an exemplary routine for adjusting tone and equalization settings of an audio source based upon a genre of audio provided by the audio source; and
Fig. 4 is a flow chart of an exemplary routine for adjusting a volume of an audio system based upon a vehicle speed, a window position and/or a vehicle location.

### Description of the Preferred Embodiments

According to the present invention, audio related operator usage patterns are monitored during audio system operation to determine operator preferences as related to the audio system. It should be appreciated that a data stream may be monitored and operator usage patterns may be developed in a number of ways. According to one embodiment of the present invention, a Driver Adaptive Learning Algorithm and System (DALAS) is utilized to monitor the data stream. Thus, using technology, such as DALAS, allows an audio system to learn operator usage patterns and perform various adjustments of the audio system autonomously, i.e., without operator intervention. DALAS technology is disclosed in U.S. Patent Application Serial No. 10/684,757 (DP-302978), entitled Driver Adaptive Collision Warning System, and filed October 14, 2003, the entire disclosure of which is hereby incorporated herein by reference in its entirety.

It should be appreciated that operator usage patterns can be utilized to control and select an audio source based on operator listening preferences for a day of the week and a time of the day as determined by the operator usage patterns. Thus, an audio system so configured can autonomously select a particular audio source, for example, an FM radio, an AM radio, a satellite digital audio receiver, a compact disc (CD) player, a cassette tape player, a motion picture expert group audio layer 3 (MP3) file player, among other such devices. Further, utilizing driving patterns and/or location data, it is possible to determine when a signal intensity is degraded such that an antenna associated with, for example, an FM/AM radio or satellite digital audio receiver can be tuned to provide better reception. It should be appreciated that such techniques can readily be implemented within commercially available audio systems by adding memory for computational and storage purposes. Thus, using software that is resident in an audio system memory allows the system to monitor and learn the preferences of a particular operator over time and then make adjustments automatically, without operator intervention.

Today, increasingly, audio includes associated data that identifies a particular genre for the audio. When such information is available, the genre can be utilized to autonomously change the tone/equalization settings based on the preferences of the operator, as determined by operator usage patterns. It should be appreciated that if the genre data is not available with a particular piece of audio, the system may utilize default tone/equalization settings or analyze the audio spectrum of the received audio and determine an operator specific suitable tone/equalization setting.

According to yet other embodiments of the present invention, the volume of the audio provided by the audio source may be adjusted based upon a number of factors, which are correlated to operator usage patterns. For example, the volume setting can be adjusted based upon the preferences of the operator and a motor vehicle speed, the preferences of the operator and a window position of a window of the motor vehicle and/or the preferences of the operator (as indicated by the operator usage patterns) and a location of the motor vehicle, which location may be provided by various techniques, such as a global positioning system (GPS) receiver.

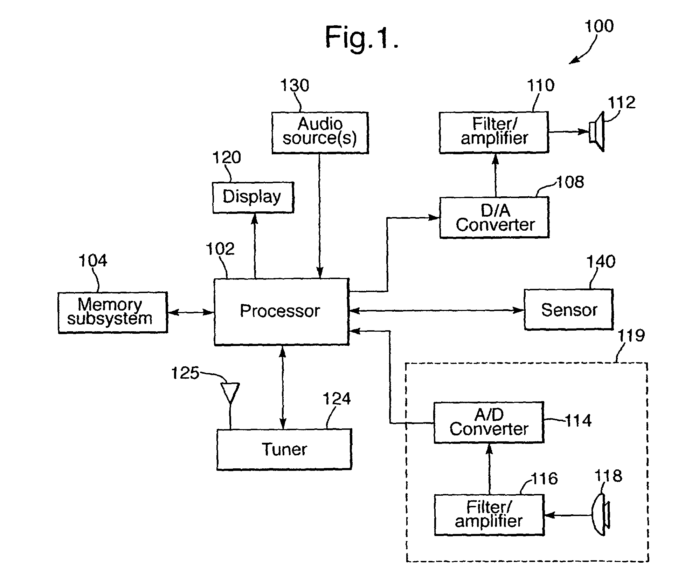

Fig. 1 depicts a block diagram of an exemplary audio system 100 that may be implemented within a motor vehicle (not shown) and autonomously controlled based on operator usage patterns. As shown, the system 100 includes a processor 102 coupled to a first audio source 124, e.g., an AM/FM tuner, a second audio source 130, e.g., including a compact disk (CD) player, a digital versatile disk (DVD) player, a cassette tape player, a satellite digital audio receiver and an MP3 file player, and a display 120. The processor 102 may control the tuner 124 and audio sources 130, at least in part, as dictated by manual or voice input supplied by an operator of the system 100, as well as based upon operator usage patterns. In audio systems that include voice recognition technology, different operators can be distinguished from each other by a voice input or a manual input.

The processor 102 controls audio provided to a listener, via the speaker 112 and may also supply various information to an operator, via the display 120 and/or the speaker 112. As used herein, the term processor may include a general purpose processor, a microcontroller (i.e., an execution unit with memory, etc., integrated within a single integrated circuit), an application specific integrated circuit (ASIC), a programmable logic device (PLD) or a digital signal processor (DSP). The processor 102 is also coupled to a memory subsystem 104, which includes an application appropriate amount of memory (e.g., volatile and non-volatile memory), which provides storage for operator usage patterns and the routines that determine the operator usage patterns. The memory subsystem 104 may also provide a storage area for one or more speech recognition applications.

As is also shown in Fig. 1, an audio input device 118 (e.g., a microphone) is coupled to a filter/amplifier module 116. The filter/amplifier module 116 filters and amplifies the voice input provided by an operator through the audio input device 118. This voice input may be utilized to distinguish one operator from another operator such that operator usage patterns for multiple operators may be implemented. The filter/amplifier module 116 is also coupled to an analog-to-digital (A/D) converter 114, which digitizes the voice input from the operator and supplies the digitized voice to the processor 102 which may execute a speech recognition application, which causes the voice input to be compared to system recognized commands or may be used to identify a specific operator. In general, the audio input device 118, the filter/amplifier module 116 and the A/D converter 114 form a voice input circuit 119.

The processor 102 may execute various routines in determining whether the voice input corresponds to a system recognized command and/or a specific operator. The processor 102 may also cause an appropriate voice output to be provided to the operator through an audio output device 112. The synthesized voice output is provided by the processor 102 to a digital-to-analog (D/A) converter 108. The D/A converter 108 is coupled to a filter/amplifier section 110, which amplifies and filters the analog voice output. The amplified and filtered voice output is then provided to audio output device 112 (e.g., a speaker). The processor 102 is also coupled to a sensor 140, e.g., a global positioning system (GPS) receiver, a wheel speed sensor and/or a window position sensor, which allows the system 100 to sense a relevant characteristic, e.g., determine a location of an associated motor vehicle, a speed of the motor vehicle and/or a position of a window of the motor vehicle.

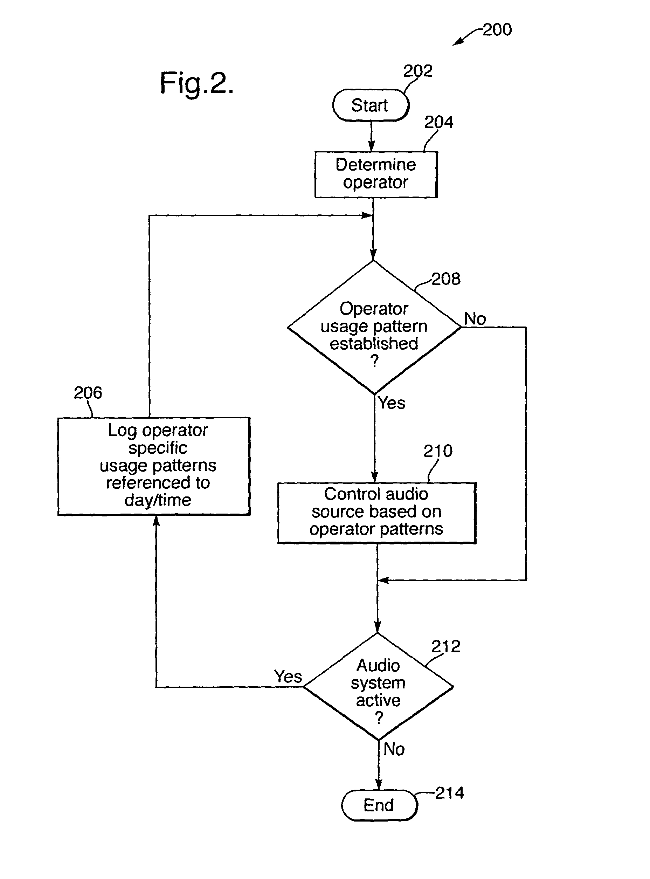

With reference to Fig. 2, an exemplary routine 200 is depicted that executes when the audio system 100 is active. The routine 200, which is executed by the processor 102, sets operating parameters for the audio system 100 based upon operator specific usage patterns. In step 202, the routine 200 is initiated at which point control transfers to step 204. In step 204, the processor 102 identifies a specific operator. As mentioned above, the operator may be identified by a manual input or voice input or some other input, e.g., another biometric input. When an operator cannot be identified, the processor 102 may create a new operator or use a default operator to control the audio system 100.

Next, in decision step 208, the processor 102 determines whether operator specific usage patterns have been established. If so, control transfers to step 210, where the processor 102 controls the tuner 124 and/or the audio source 130 based upon the operator specific usage patterns, before transferring control to decision step 212. When operator specific usage patterns have not been established in step 208, control passes directly to step 212, where the processor 102 determines if the audio system 100 is still active. If so, control passes from step 212 to step 206, where the processor 102 logs or continues to log operator specific usage patterns, for example, referenced to a day and time. From step 206, control returns to step 208. When the audio system 100 is no longer active in step 212, control passes to step 214 where the routine 200 terminates.

It should be appreciated that an operator usage pattern may be established in a number of different ways. For example, a listening pattern may be established only after a specific station is played on a specific day during a specific time period multiple times. Further, an operator usage pattern may change over time, depending upon the operator's interest. As previously discussed, the processor 102 may select an audio source based upon operator listening preferences for a day of the week and a time of the day, as determined by the operator usage patterns. Further, when the audio source is an AM/FM tuner, the processor 102 may tune the AM/FM tuner to an appropriate radio station based upon the operator usage patterns.

In a typical situation, an audio source may be selected at power-up and may include various devices, such as an AM/FM tuner, a compact disc (CD) player, a digital versatile disc (DVD) player, a cassette tape player, a satellite digital audio receiver and an MP3 file player. Based upon operator usage patterns and/or a motor vehicle location, as provided by, for example, a GPS receiver, an antenna associated with an AM/FM tuner may also be tuned to provide optimal signal reception. Further, as previously mentioned, the volume of the audio produced by the audio source may be controlled by the processor 102 based upon a speed of a motor vehicle and the operator usage patterns, which include an operator volume preference for the speed.

In another embodiment, a volume of the audio produced by the audio source may be adjusted based upon a position of a window and operator usage patterns, which include an operator volume preference for the window position. A volume of the audio produced by the audio source may also be adjusted based upon a location of the motor vehicle (to compensate for road surface conditions) and operator usage patterns, which include an operator volume preference for the location of the motor vehicle.

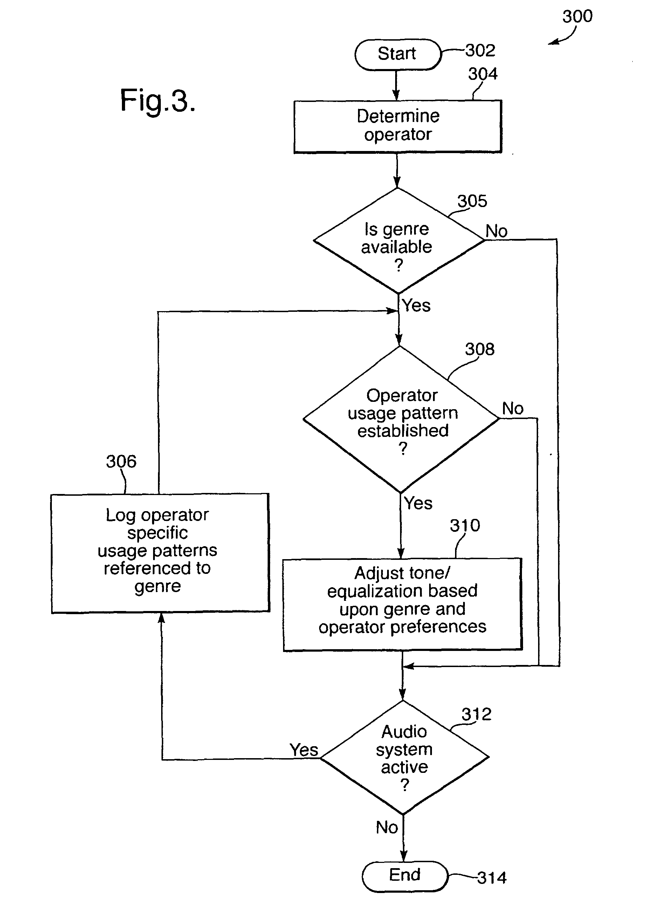

With reference to Fig. 3, a routine 300 is depicted, which may be executed in parallel with the routine 200. The routine 300 is executed by the processor 102 and executes while the audio system 100 is active. More specifically, the routine 300 is initiated in step 302, at which point control transfers to step 304 where the processor 102 identifies an operator of the audio system 100. As is mentioned above, the identity of the operator may be determined by a manual input, voice input or another biometric input. Next, in decision step 305, the processor 102 (executing the routine 300) determines whether genre data is available with the current audio source. If so, control transfers from step 305 to decision step 308, where the processor 102 determines whether operator specific usage patterns are established.

When usage patterns are established in step 308, control transfers to step 310, where the processor 102 adjusts the tone/equalization of the audio based upon a genre and operator tone/equalization preferences, and then to decision step 312. When the genre is not available in step 305, control transfers directly to step 312. In step 312, the processor 102 determines whether the audio system 100 is still active. If so, control transfers to step 306, where the processor 102 logs or continues to log operator specific usage patterns, and then to step 308. Otherwise, control transfers from step 312 to step 314, where the routine 300 terminates.

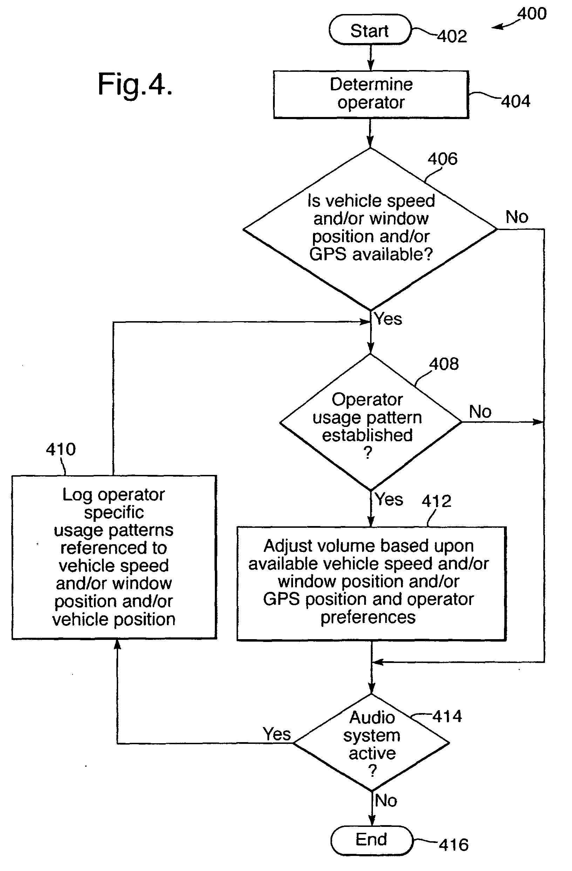

With reference to Fig. 4, a routine 400 is depicted, which may be executed in parallel with the routines 200 and 300. The routine 400 executes on the processor 102 while the audio system 100 is active. More specifically, the routine 400 is initiated in step 402, at which point control transfers to step 404, where the processor 102 identifies an operator of the audio system 100. As is mentioned above, the identity of the operator may be determined by a manual input, voice input or another biometric input. Next, in decision step 406, the processor 102 (executing the routine 400) determines whether vehicle speed and/or window position and/or GPS information is available. If so, control transfers from step 406 to decision step 408, where the processor 102 determines whether operator specific usage patterns are established.

When operator usage patterns are established in step 408, control transfers to step 412, where the processor 102 adjusts an audio volume based upon vehicle speed and/or window position and/or vehicle location and operator preferences for the vehicle speed and/or window position and/or vehicle location, and then to decision step 414. When the information is not available in step 408, control transfers directly to step 414. In step 414, the processor 102 determines whether the audio system 100 is still active. If so, control transfers to step 410, where the processor 102 logs or continues to log operator specific usage patterns. Otherwise, control transfers from step 414 to step 416, where the routine 400 terminates.

Accordingly, an audio system has been described herein that controls an audio source based upon operator specific usage patterns. Such an audio system may advantageously be implemented within a motor vehicle to more readily allow a driver of the vehicle to drive in a safer more effective manner.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A method (200, 300, 400) for setting operating parameters of an audio system (100) based upon operator usage patterns, comprising the steps of:
monitoring audio related operator usage patterns of an audio system (206, 306, 410); and
controlling an audio source (124, 130) based upon the operator usage patterns (210, 310, 412).

2. The method (200) of claim 1, further including the step of:
selecting the audio source (124, 130) based on operator listening preferences for a day of the week and a time of the day as determined from the operator usage patterns.

3. The method (200) of claim 2, wherein the audio source (124, 130) is an AM/FM tuner (124) and the step of controlling the audio source (124, 130) based upon the operator usage patterns (210, 310, 412) includes the step of:
tuning the AM/FM tuner (124) to an appropriate channel based upon the operator usage patterns.

4. The method (200) of claim 2, wherein the audio source (124, 130) is selected at power-up.

5. The method (200, 300, 400) of claim 1, wherein the audio source (124, 130) includes at least one of an AM/FM tuner, a compact disk (CD) player, a digital versatile disk (DVD) player, a cassette tape player, a satellite digital audio receiver and an MP3 file player.

6. The method (200) of claim 1, wherein the audio source (124, 130) is an AM/FM tuner (124) and further including the step of:
tuning an antenna associated with the AM/FM tuner (124) based on at least one of the operator usage patterns and a motor vehicle location when a radio signal is correlated with at least one of the operator usage patterns and the motor vehicle location.

7. The method (200) of claim 6, wherein the motor vehicle location is provided by a global positioning system (GPS) receiver (140).

8. The method (300) of claim 1, further including the steps of:
determining a genre associated with audio provided by the audio source (305); and
adjusting a tone setting of the audio based upon the genre and the operator usage patterns, wherein the operator usage patterns include an operator tone preference for the genre (310).

9. The method (300) of claim 8, further including the step of:
adjusting an equalization setting of the audio source (124, 130) based upon the genre and the operator usage patterns, wherein the operator usage patterns include an operator equalization preference for the genre (310).

10. The method (400) of claim 1, further including the steps of:
determining a speed of a motor vehicle (406); and
adjusting a volume of audio produced by the audio source (124, 130) based upon the speed and the operator usage patterns (412), wherein the operator usage patterns include an operator volume preference for the speed.

11. The method (400) of claim 1, further including the steps of:
determining a position of a window of a motor vehicle (406); and
adjusting a volume of audio produced by the audio source (124, 130) based upon the position of the window and the operator usage patterns (412), wherein the operator usage patterns include an operator volume preference for the position.

12. The method (400) of claim 1, further including the steps of:
determining a location of a motor vehicle (406); and
adjusting a volume of audio produced by the audio source (124, 130) based upon the location of the motor vehicle and the operator usage patterns (412), wherein the operator usage patterns include an operator volume preference for the location.

13. The method (200, 300, 400) of claim 1, wherein the audio related operator usage patterns include one of an operator preferred audio source based on a time of the day and a day of the week, a first operator preferred volume for audio provided by the audio source (124, 130) based on a speed of a motor vehicle, a second preferred operator volume for the audio based on a location of the motor vehicle, a third operator preferred volume for the audio based on a genre of the audio, a fourth operator preferred volume for the audio based on a position of a window of the motor vehicle, an operator preferred tone for the audio based on a genre of the audio and an operator preferred equalization for the audio based on the genre of the audio.

14. An audio system (100) that sets operating parameters based upon operator usage patterns, comprising:
a processor (102);
a memory subsystem (104) coupled to the processor (102), the memory subsystem (104) storing code that when executed instructs the processor (102) to perform the steps of:
monitoring audio related operator usage patterns of an audio system (206, 306, 410); and
controlling an audio source (124, 130) based upon the operator usage patterns (210, 310, 412).

15. The system (100) of claim 14, wherein the code when executed instructs the processor (102) to perform the additional step of:
selecting the audio source (124, 130) based on operator listening preferences for a day of the week and a time of the day as determined from the operator usage patterns.

16. The system (100) of claim 15, wherein the audio source (124, 130) is an AM/FM tuner (124) and the code when executed instructs the processor (102) to perform the additional step of:
tuning the AM/FM tuner (124) to an appropriate channel based upon the operator usage patterns.

17. The system (100) of claim 15, wherein the audio source (124, 130) is selected at power-up.

18. The system (100) of claim 14, wherein the audio source (124, 130) includes at least one of an AM/FM tuner, a compact disk (CD) player, a digital versatile disk (DVD) player, a cassette tape player, a satellite digital audio receiver and an MP3 file player.

19. The system (100) of claim 14, wherein the audio source (124, 130) is an AM/FM tuner (124) and the code when executed instructs the processor (102) to perform the additional step of:
tuning an antenna associated with the AM/FM tuner (124) based on at least one of the operator usage patterns and a motor vehicle location when a radio signal is correlated with at least one of the operator usage patterns and the motor vehicle location.

20. The system (100) of claim 19, wherein the motor vehicle location is provided by a global positioning system (GPS) receiver (140).

21. The system (100) of claim 14, wherein the code when executed instructs the processor (102) to perform the additional steps of:
determining a genre associated with audio provided by the audio source (305); and
adjusting a tone setting of the audio based upon the genre and the operator usage patterns, wherein the operator usage patterns include an operator tone preference for the genre (310).

22. The system (100) of claim 21, wherein the code when executed instructs the processor (102) to perform the additional step of:
adjusting an equalization setting of the audio source (124, 130) based upon the genre and the operator usage patterns, wherein the operator usage patterns include an operator equalization preference for the genre (310).

23. The system (100) of claim 14, wherein the code when executed instructs the processor (102) to perform the additional steps of:
determining a speed of a motor vehicle (406); and
adjusting a volume of audio produced by the audio source (124, 130) based upon the speed and the operator usage patterns (412), wherein the operator usage patterns include an operator volume preference for the speed.

24. The system (100) of claim 14, wherein the code when executed instructs the processor (102) to perform the additional steps of:
determining a position of a window of a motor vehicle (406); and
adjusting a volume of audio produced by the audio source (124, 130) based upon the position of the window and the operator usage patterns (412), wherein the operator usage patterns include an operator volume preference for the position.

25. The system (100) of claim 14, wherein the code when executed instructs the processor (102) to perform the additional steps of:
determining a location of a motor vehicle (406); and
adjusting a volume of audio produced by the audio source (124, 130) based upon the location of the motor vehicle and the operator usage patterns (412), wherein the operator usage patterns include an operator volume preference for the location.

26. The system (100) of claim 14, wherein the audio related operator usage patterns include one of an operator preferred audio source (124, 130) based on a time of the day and a day of the week, a first operator preferred volume for audio provided by the audio source (124, 130) based on a speed of a motor vehicle, a second preferred operator volume for the audio based on a location of the motor vehicle, a third operator preferred volume for the audio based on a genre of the audio, a fourth operator preferred volume for the audio based on a position of a window of the motor vehicle, an operator preferred tone for the audio based on a genre of the audio and an operator preferred equalization for the audio based on the genre of the audio.

27. An audio system (100) that sets operating parameters based upon operator usage patterns, comprising:
a processor (102);
an audio source (124, 130) coupled to the processor (102);
a memory subsystem (104) coupled to the processor (102), the memory subsystem (104) storing code that when executed by the processor (102) instructs the processor (102) to perform the steps of:
monitoring audio related operator usage patterns of the audio system for a predetermined period of time (206, 306, 410); and
controlling the audio source (124, 130) based upon the operator usage patterns monitored during the predetermined period of time (210, 310, 412).

28. The system (100) of claim 27, wherein the code when executed instructs the processor (102) to perform the additional step of:
selecting the audio source (124, 130) based on operator listening preferences for a day of the week and a time of the day as determined from the operator usage patterns.

29. The system (100) of claim 28, wherein the audio source (124, 130) is an AM/FM tuner (124) and the code when executed instructs the processor (102) to perform the additional step of:
tuning the tuner (124) to an appropriate channel based upon the operator usage patterns.

30. The system (100) of claim 28, wherein the audio source (124, 130) is selected at power-up.

31. The system (100) of claim 27, wherein the audio source (124, 130) includes at least one of an AM/FM tuner, a compact disk (CD) player, a digital versatile disk (DVD) player, a cassette tape player and an MP3 file player.
